## Europäisches Patentamt
## European Patent Office
## Office européen des brevets

(19)

(11) Veröffentlichungsnummer: **0 141 213**
**B1**

(12) # EUROPÄISCHE PATENTSCHRIFT

(45) Veröffentlichungstag der Patentschrift:
**14.12.88**

(21) Anmeldenummer: **84111099.2**

(22) Anmeldetag: **18.09.84**

(51) Int. Cl.⁴: **H 03 K 17/725, H 02 P 1/58**

(54) **Stromgesteuertes Halbleiterrelais.**

(30) Priorität: **21.10.83 DE 3338225**

(43) Veröffentlichungstag der Anmeldung:
**15.05.85 Patentblatt 85/20**

(45) Bekanntmachung des Hinweises auf die Patenterteilung:
**14.12.88 Patentblatt 88/50**

(84) Benannte Vertragsstaaten:
**DE FR IT SE**

(56) Entgegenhaltungen:
**DE-A-2 332 449**
**DE-A-2 912 114**
**FR-A-2 371 726**
**US-A-3 763 377**
**US-A-3 936 705**

(73) Patentinhaber: **ROBERT BOSCH GMBH, Postfach 50, D-7000 Stuttgart 1 (DE)**

(72) Erfinder: **Hornung, Friedrich, Dipl.- Ing., Am Ochsenwald 10A, D-7000 Stuttgart 80 (DE)**
Erfinder: **Gerschner, Martin, Wilhelm- Hachtel- Strasse 38, D-7022 Leinfelden- Echterdingen 1 (DE)**

EP 0 141 213 B1

## Beschreibung

### Stand der Technik

Die Erfindung geht aus von einer Ansteuerschaltung für einen Halbleiterschalter nach der Gattung des Hauptanspruchs. Es ist bereits allgemein bekannt, für verschiedene Geräte Zusatzgeräte anzubieten, die mit dem Hauptgerät einzuschalten sind, ohne daß zusätzliche Schaltverbindungen erforderlich sind. So sind beispielsweise Staubsauger bekannt, die eine weitere Steckdose aufweisen, an die ein Klopfsauger anschließbar ist. Bei diesen Geräten wird das Zusatzgerät, z. B. der Klopfsauger, zusammen mit dem Hauptgerät, z. B. dem Staubsauger, eingeschaltet. Auch Staubsauger die in Verbindung mit Elektrowerkzeugen zur Staubabsaugung angeboten werden, können elektrisch kombiniert werden. Im Gegensatz zur obigen Geräteart wird hier jedoch das Hauptgerät, z. B. ein Industriestaubsauger, durch das Zusatzgerät, z. B. eine Bohrmaschine, eingeschaltet Dies bedingt eine grundsätzlich andere Schalt- bzw. Steuerungsart. Genügt im ersten Fall eine Steckdose, die zum Motor des Hauptgeräts parallelgeschaltet wird, benötigt man im zweiten Fall zusätzlich zur Steckdose ein Steuerelement, das den Motorstromkreis des Hauptgeräts erst dann einschaltet, wenn der Stromkreis des Zusatzgeräts eingeschaltet wird. Als geeignetes Steuerelement verwendet man bisher z. B. stromgesteuerte mechanische Relais. Diese stromgesteuerte Relais weisen einen Schalt- und einen Steuerkreis auf. Diese Relais werden mit dem Steuerkreis direkt in den Stromkreis des Zusatzgeräts geschaltet. Sie sprechen an, wenn von dem Gerät Strom aufgenommen wird. Zu diesem Zwecke weisen die stromgesteuerten Relais eine Stromwicklung auf. Nachteilig bei diesen Anordnung ist, daß die Relais nicht sicher schalten, wenn ein minimaler Stromwert unterschritten wird oder daß sie durch einen zu hohen Stromwert überlastet werden können. Wird beispielsweise ein Elektrowerkzeug im Leerlauf oder bei geringer Last betrieben, so kann es passieren, daß eine angeschlossene Staubabsaugvorrichtung deswegen nicht einschaltet, weil das Relais auf den Leerlaufstrom nicht anspricht. Andererseits besteht die Gefahr, daß bei einer starken Belastung des Elektrowerkzeuges der maximale Stromwert durch das Relais überschritten wird und das Relais dadurch zerstört wird.

Aus der US-A-3 763 377 ist bereits bekannt, daß zur Messung des Laststromes eines ersten Verbrauchers ein Übertrager verwendet wird, über dessen Sekundärwicklung einem Halbleiterschalter eine dem Laststrom proportionale Spannung zugeführt ist. Im Leistungspfad des Halbleiterschalters ist ein zweiter Verbraucher geschaltet, der durch das Schalten des Halbleiterschalters eingeschaltet wird. Bei dieser Schaltungsanordnung ist es ungünstig, daß der Spannungsabfall im Strommeßpfad des Übertragers nicht begrenzt ist, wodurch eine unerwünscht hohe Verlustleistung mit entsprechender thermischer Belastung des Übertragers auftreten kann. Diese Anordnung macht auch Schwierigkeiten, wenn große Differenzen im Steuerstrom auftreten. Beispielsweise reicht bei niedrigen Strömen im Primärkreis die Zündenergie nicht aus, weil entweder die notwendigen Zündströme für den Triac nicht erreicht werden, oder der Triac wird bei hohem Primärstrom durch zu hohe Zündströme an der Obergrenze überlastet. Ein weiterer Nachteil dieser Anordnung ist, daß ein kostenintensiver und schwerer Übertrager verwendet werden muß, der insbesondere bei Elektrowerkzeugen nur schwer unterzubringen ist und durch sein Gewicht die Handhabbarkeit des Elektowerkzeuges erschwert. Als weiterer Nachteil ist anzusehen, daß die Kombination von Übertrager und Triac störempfindlich ist, bei Netzstörungen können sich ungewollte Einschaltungen des Triacs ergeben.

### Vorteile der Erfindung

Die erfindungsgemäße Ansteuerschaltung mit den kennzeichnenden Merkmalen des Hauptanspruchs hat demgegenüber den Vorteil, daß nur einfache elektronische Bauelemente verwendet sind. Dadurch läßt sich die Ansteuerschaltung sehr kompakt und preisgünstig aufbauen. Als weiterer Vorteil ist anzusehen, daß die Schaltungsanordnung auch bei großen Unterschieden des Stromes des Zusatzgeräts sicher arbeitet.

Durch die in den Unteransprüchen aufgeführten Maßahmen sind vorteilhafte Weiterbildungen und Verbesserungen der im Hauptanspruch angegebenen Ansteuerschaltung möglich. Vorteilhaft ist es insbesondere, dem Widerstand im Hauptstromkreis ein antiparalleles Diodenpaar parallel zu schalten. Durch diese Maßnahme wird der Spannungsabfall am Widerstand so begrenzt, daß weder der Widerstand noch der Halbleiterschalter gefährdet werden. Durch diese Maßnahme ist es möglich, nicht nur Thyristoren oder Triacs als Halbleiter einzusetzen, sondern auch Transistoren. Besonders vorteilhaft sind jedoch Thyristoren und Triacs. Durch die Anordnung von weiteren Widerständen im Steuerstromkreis wird einerseits erreicht, daß der Steuerstrom auf die zulässigen Werte begrenzt wird und andererseits durch die geeignete Wahl der Widerstände eine Vielzahl von Thyristoren und Triacs verwendbar ist.

### Zeichnung

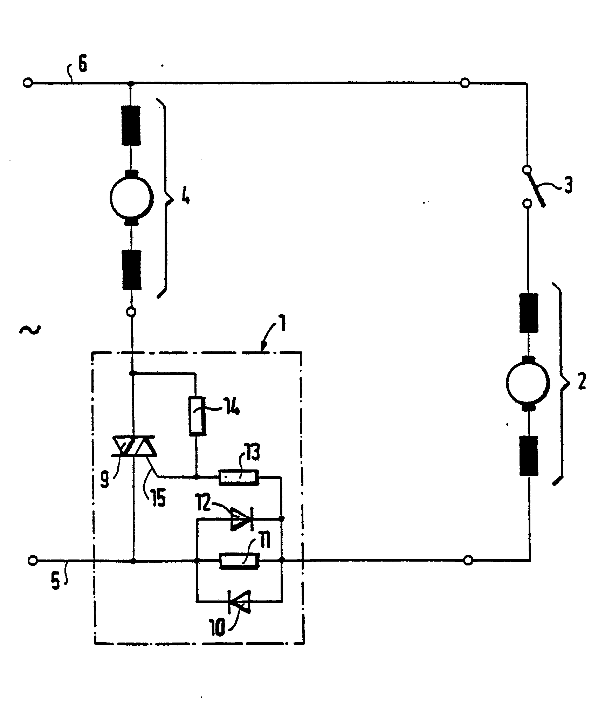

Ein Ausführungsbeispiel der Erfindung ist in der Zeichnung dargestellt und in der nachfolgenden Beschreibung näher erläutert.

### Beschreibung des Ausführungsbeispiels

Die Leitungen 5 und 6 der Figur sind an eine Wechselspannungsquelle, beispielsweise das Stromversorgungsnetz eines Haushaltes, angeschlossen. Die Leitung 6 führt zu einem Ein-Aus-Schalter 3, dem ein Motor 2 folgt. Der Motor 2 ist als Universalmotor ausgebildet, der beispielsweise ein Elektrowerkzeug oder ein Haushaltsgerät antreibt. Im weiteren soll jedoch die Erfindung in Verbindung mit einem Elektrowerkzeug erläutert werden. Dem Elektromotor 2 folgt ein Widerstand 11, der in den Stromkreis des Motors 2 geschaltet ist. Der Widerstand 11 steht mit der weiteren Leitung 5 in Verbindung. Parallel zum Widerstand 11 sind zwei Dioden 10 und 12 geschaltet, die antiparallel geschaltet sind. An die Leitung 6 ist ein weiterer Motor 4 angeschlossen. Dieser weitere Motor 4 dient z. B. dazu, eine Staubabsaugung zu betreiben. Dadurch wird erreicht, daß der beispielsweise beim Bohren mit einer Schlagbohrmaschine entstehende Staub sofort abgesaugt wird, so daß es nicht staubt und die Umgebung der Bohrstelle nicht verschmutzt wird. Dem Motor 4 folgt ein Triac 9 der seinerseits mit der Spannungsversorgungsleitung 5 verbunden ist. Der Motor 4 mit dem Triac 9 bildet einen Stromkreis , an den das Gerät, das durch das Elektrowerkzeug geschaltet werden soll, beispielsweise die Staubabsaugung, anschließbar ist.

Zur Ansteuerung des Triacs 9 ist an der Verbindungsleitung zwischen dem Motor 2 und dem Widerstand 11 ein Widerstand 13 angeschlossen, der zum Gate 15 des Triacs 9 führt. Des weiteren ist ein Widerstand 14 vom Gate 15 zur Verbindungsleitung zwischen Motor 4 und Triac 9 geschaltet. Diese Bauelemente bilden den Ansteuerkreis für den Triac 9. Die gesamte Anordnung mit den Widerständen 11, 13 und 14, den Dioden 10 und 12 und dem Triac 9 ist als stromgesteuertes Halbleiterrelais 1 gekennzeichnet.

Die Widerstände 11, 13 und 14 sind in der Summe und im Verhältnis zueinander so gewählt, daß einerseits der Spannungsteilerstrom kleiner ist als der minimale Steuerstrom für den Triac 9 und andererseits die Spannung am Gate des Triacs 9 im Sinusmaximum der Versorgungsspannung etwa die Hälfte der zum Zünden notwendigen Spannung beträgt. Um den Wärmeverlust gering zu halten ist außerdem der Widerstand 11 cirka um den Faktor 10 kleiner als der Widerstand 13, damit ist auch der Spannungsabfall am Widerstand 11 vernachlässigbar klein gegenüber der Durchlaßspannung der Dioden 10 und 12. Ist nunmehr der Schalter 3 ausgeschaltet, d. h. es fließt im Stromkreis des Zusatzgeräts kein Strom, so erreicht die Spannung am Gate 15 nicht den notwendigen Wert, den Triac 9 zu zünden. Der Motor 4 bleibt stromlos, so daß der Staubsauger nicht anlaufen kann. Wird nun der Elektromotor 2 des Zusatzgeräts durch Betätigen des Schalters 3 eingeschaltet, so führt der Strom des Zusatzgeräts zu einem Spannungsabfall am Widerstand 11. Dieser Spannungsabfall ist stromabhängig, wird jedoch durch die beiden Dioden 10 und 12 auf die Diodendurchlaßspannung begrenzt, so daß auch bei hoher Stromaufnahme der Spannungsabfall an Widerstand 11 den Wert von ca. 1 V nicht überschreiten kann. Der Spannungsabfall am Widerstand 11 addiert sich in jeder Netzhalbwelle gleichphasig zum Spannungsabfall am Widerstand 13. Am Gate 15 erhält nunmehr der Triac 9 eine erhöhte Spannung, die zum Zünden ausreicht. Dadurch wird der Motor 4 eingeschaltet, und beispielsweise die Staubabsaugung in Betrieb genommen.

Mit Hilfe der Widerstände 13 und 14 ist die Schaltung auf jeden Triac-Typ abstimmbar. Durch den Widerstand 11 wird die untere Ansprechgrenze festgelegt. Die Ansprechgrenze ist umso niedriger, je hochohmiger der Widerstand 11 ist. Wie bereits oben erwähnt, dienen die beiden antiparallelen Dioden 10 und 12 als Begrenzerdioden, die den Widerstand 11 vor einer Überlastung schützen. Hierdurch wird auch vermieden, daß der Steuerstrom für den Triac 9 unzulässig hohe Werte annimmt. Die Belastbarkeit der Dioden 10 und 12 bestimmt schließlich die obere Stromgrenze im Haupstromkreis. Da an den Dioden nur geringe Sperrspannungen auftreten, sind auch billige Typen sehr gut zu verwenden. Die Schaltungsanordnung nach der Erfindung ist für einen großen Steuerstrombereich geeignet. Versuche haben gezeigt, daß ein sicheres Funktionieren der Schaltungsanordnung auch dann noch gegeben ist, wenn zwischen dem minimalen Strom und dem maximalen Strom der Zusatzgeräts ein Verhältnis von 50 gegeben ist.

**Patentansprüche**

1. Elektrisches Haushaltsgerät oder Handwerkzeug (4) für ein elektrisch betriebenes Zusatzgerät (2), dessen Strom das elektrische Haushaltsgerät oder Handwerkzeug (4) mittels eines in seiner Zuleitung liegenden Halbleiterschalter (9) einschaltet, dadurch gekennzeichnet, daß in der Zuleitung zum Zusatzgerät (2) ein Handschalter (3) angeordnet ist, daß in Reihe zum Zusatzgerät (2) ein Widerstand (11) eingeschaltet ist, dessen Spannungsabfall dem Zündkreis (13, 14) des Halbleiterschalters (9) zugeführt ist, und daß parallel zum Widerstand (11) zwei Dioden (10, 12) antiparallel geschaltet sind.

2. Elektrisches Haushaltsgerät oder Handwerkzeug nach Anspruch 1, dadurch gekennzeichnet, daß der Halbleiterschalter (9) als Thyristor oder Triac ausgebildet ist.

3. Elektrisches Haushaltsgerät oder Handwerkzeug nach Anspruch 2, dadurch gekennzeichnet, daß das Gate (15) des Thyristors oder des Triacs (9) über einen Widerstand (13) zwischen dem Widerstand (11) und dem Anschluß des Zusatzverbrauchers (2) angeschlossen ist.

4. Elektrisches Haushaltsgerät oder Handwerkzeug nach einem der vorhergehenden Ansprüche, dadurch gekennzeichnet, daß ein weiterer Widerstand (14) zwischen dem Gate des Thyristors oder Triacs (9) und dessen Anode geschaltet ist.

**Claims**

1. Domestic electric device or hand tool (4) for an electrically operated accessory device (2), the current of which switches on the domestic electric device or hand tool (4) by means of a semiconductor switch (9) which is located in its feed line, characterized in that a manual switch (3) is arranged in the feed line to the accessory device (2), that a resistor (11) is connected in series with the accessory device (2), the voltage drop of which resistor is supplied to the firing circuit (13, 14) of the semiconductor switch (9), and that in parallel with the resistor (11), two diodes (10, 12) are connected antiparallel.

2. Domestic electric device or hand tool according to claim 1, characterized in that the semiconductor switch (9) is constructed as a thyristor or triac.

3. Domestic electric device or hand tool according to patent claim 2, characterized in that the gate (15) of the thyristor or the triac (9) is connected via a resistor (13) between the resistor (11) and the connection of the accessory load (2).

4. Domestic electric device or hand tool according to one of the preceding claims, characterized in that a further resistor (14) is connected between the gate of the thyristor or triac (9) and its anode.

**Revendications**

1. Appareillage électro-ménager ou outillage à main (4) pour un appareil auxiliaire (2) entraîné électriquement dont le courant fait démarrer l'appareillage électro-ménager ou l'outillage à main (4) au moyen d'un relais à semi-conducteurs (9) se trouvant sur sa conduite d'alimentation, caractérisé en ce que, dans cette dernière, est placé un interrupteur à main (3) pour l'appareillage auxiliaire (2), qu'une résistance (11) est montée en série avec l'appareillage auxiliaire (2), dont la chute de tension est amenée au circuit d'excitation (13, 14) du relais à semiconducteurs (9) et que deux diodes (10, 12) en opposition sont montées en parallèle avec la résistance (11).

2. Appareillage électro-ménager ou outillage à main selon la revendication 1, caractérisé en ce que le relais à semi-conducteurs (9) est formé d'un triac ou d'un thyristor.

3. Appareillage électro-ménager ou outillage à main selon la revendication 2, caractérisé en ce que la porte (15) du thyristor ou du triac (9) est reliée par une résistance (13) entre la résistance (11) et le raccordement de l'appareillage additionnel (2).

4. Appareillage électro-ménager ou outillage à main selon l'une des revendications précédentes, caractérisé en ce qu'une autre résistance (14) est branchée entre la porte du thyristor ou du triac (9) et son anode.

0 141 213

1